# EUROPEAN PATENT APPLICATION

(11) **EP 2 843 079 A1**
(43) Date of publication of application: **04.03.2015**
(21) Application number: 13182352.8
(22) Date of filing: 30.08.2013
(51) Int. Cl.: C23C 14/14, C23C 14/28, H01L 21/02

(54) **Process and donor carrier for manufacturing a semi-conductor device using light induced transfer.**

(71) Applicant: Nederlandse Organisatie voor Toegepast -Natuurwetenschappelijk Onderzoek TNO, 2628 VK Delft (NL); Koninklijke Philips N.V., 5656 AE Eindhoven (NL); Coherent Europe B.V., 3526 KL Utrecht (NL)
(72) Inventor: Lifka, Herbert, 5656 AE Eindhoven (NL); Mandamparambil, Rajesh, 2628 VK Delft (NL); Prenen, An Maria, 2628 VK Delft (NL); Jense, Wouter, 2628 VK Delft (NL); Moorhouse, Colin, 3526 KL Utrecht (NL); Kuether, Lars, 3526 KL Utrecht (NL)
(74) Representative: Jansen, Cornelis Marinus

(57) **Abstract**

A semi-conductor device is manufactured using a light induced forward transfer process, by transferring donor material from a transparent donor substrate. A donor layer with semi-conductor material and doping material is used. The donor layer may be of amorphous silicon with implanted doping. The donor substrate and a target substrate are placed facing each other. The donor layer is irradiated with light through the donor substrate at a selected position on the surface of the donor substrate, using sufficient energy to melt the donor layer at the irradiated position and to transfer to the target substrate in the molten state. On the target substrate the donor material crystallizes. Successive transfer steps of this type for transferring material to the same target substrate, using donor layers having different types and/or concentrations of donor material, may be used to manufacture a more complex device.

## Description

### Field of the invention

The invention relates to a process for manufacturing a semiconductor device using light induced transfer, such as laser induced forward transfer (LIFT). Furthermore, the invention relates to a donor carrier for use in such a process.

### Background

Laser induced forward transfer (LIFT) of silicon to a host substrate is known from an article by Toet et al, titled "Laser-assisted transfer of silicon by explosive hydrogen release", published in Applied physics letters, vol. 74, 15 pages 2170-2172. In a Laser induced transfer (LIFT) process, a surface of a transparent donor substrate is placed facing a target substrate. Donor material on the surface of the donor substrate is heated by means of a laser irradiation through the donor substrate, to transfer the donor material to the target substrate. Toet et al use a substrate with amorphous silicon on its surface as donor material. Toet et al disclose that a laser pulse can be used to the melt the amorphous silicon and transfer it to the target substrate in molten form, where it crystallizes. For semi-conductor device manufacturing semi-conductor material such as silicon with activated doping is required on the target substrate.

Conventionally, doping is added to semi-conductor material in the semi-conductor device under construction. When a low doping concentration is required, this usually involves implantation, followed by a heating step to activate the doping. Alternatively, thermal diffusion of doping from a temporary doping source layer may be used. A semi-conductor layer with higher doping concentration can be manufactured by means of joint chemical vapor deposition of semi-conductor material and doping material. However, such steps complicate the device manufacturing process.

### Summary

Among others, it is an object to provide for a simplified process for manufacturing a device containing doped semi-conductor material. According to one aspect, a method of manufacturing a semi-conductor device is provided that makes use of an at least partly transparent donor substrate with a donor layer on a surface of the donor substrate, the donor layer comprising semi-conductor material and doping material. In an embodiment, the semi-conductor material is silicon. Doping such as phospor or boron may be used for example. The donor layer is irradiated with light through the donor substrate. In an embodiment, the donor layer is irradiated with a laser pulse. The donor layer is irradiated at a selected position or positions on the surface of the donor substrate, whereby the donor layer at said position or positions is melted and transferred to the target substrate where the donor layer is irradiated. Thus, a region of crystalline semi-conductor with activated doping may be created in a single step on the target substrate.

The method allows for transfer to any type of target substrate. It is extremely fast, because no doping step or activation step is needed once the semi-conductor has been transferred to the target substrate. Differently doped regions can be added in quick succession. The manufacturing does not require complex electronics and relatively unsophisticated manufacturing equipment, compared to existing semi-conductor manufacturing processes. Lithography is not necessary.

Because the region of crystalline semi-conductor is created from molten material, no high demands need be placed on the material on the donor carrier. Amorphous semi-conductor material such as amorphous silicon may be used on the donor carrier. This simplifies manufacture. When low doping concentrations are needed, the doping may be implanted into the donor layer on the donor carrier. The doping need not be activated on the donor carrier. Alternatively, a composite layer of semiconductor material and a layer of doping material may be deposited, for example by means of chemical vapor deposition. As another alternative, the donor layer may comprise sub-layers of semiconductor material and a layer of doping material. The donor carrier may be a rigid plate, made of glass for example, or a flexible carrier made of optically transparent polymer for example.

In an embodiment, the semi-conductor material is silicon. In a further embodiment the donor layer comprising silicon is irradiated with a pulse that a fluence between 0.1 J/cm2 and 1 J/cm2 per 100 nanometer of donor layer thickness, e.g between 0.1 and 0.65 1 J/cm2 and more preferably between 0.26 and 1 J/cm2 per 100 nanometer. The fluence is the amount of energy in the pulse, i.e. the average pulse power times its duration. Fluence per 100 nanometer means that when a donor layer of 100 nanometer thick is used a fluence in this range is used and with a thicker or thinner donor layer a fluence in a proportionally higher or lower range is used. In an example 0.36 J/cm2 is used for a 100 nm thick layer.

In an embodiment the donor layer comprises amorphous semi-conductor material. It may consist substantially of amorphous silicon or other semi-conductor material with added doping. In an embodiment the doping in the donor layer is implanted doping. Implantation provides for a simple method to provided a controlled doping concentration. In another embodiment the doping layer comprises a layer of semiconductor material and a layer of doping material. In this way successive deposition steps can be used to provide the semiconductor material and the doping material. In an embodiment doping concentration in the donor layer lies in a range between 10¹³ to 10²¹ doping atoms/cm³. In an embodiment the donor layer has a thickness in a range between 50 nanometer and 1000 nanometer, and more preferably between 50 and 300 nanometer, and more preferably between 100 and 300 nanometer. In an embodiment said step of irradiating the donor layer is performed by means of a laser pulse, at a wavelength at which the donor layer has a light penetration depth less than the thickness of the donor layer. In an embodiment a wavelength of 532 nanometer is used for an amorphous silicon donor layer. In an embodiment a wavelength is used at which the penetration depth lies between 100 and 400 nanometer. In an embodiment the pulse duration is between 1 and 25 nanosecond.

In an embodiment, device is manufactured by depositing a plurality of successively adjacent regions of semi-conductor material with mutually different doping type and/or doping concentration on the target substrate. The material for these regions may be prefabricated with different doping type and/or concentrations on different donor carriers or different areas on a donor carrier. Thus, a single step applied to the target substrate suffices for each differently doped region. In an embodiment the plurality of successively adjacent areas are transferred to the target substrate at successively adjacent locations on the target substrate. Thus for example a lateral field effect transistor or diode may be manufactured. In another embodiment the plurality of successively adjacent areas are transferred to the target substrate at successively on top of each other on the target substrate. Thus vertical devices like diodes or vertical bipolar transistors may be realized. The donor layer may be used to block light from reaching previously transferred regions when a next region is transferred. In this way damage to the previously transferred regions of a device can be avoided.

To support the manufacturing process prefabricated donor carriers may be provided. A set of such donor carriers with different types and/or concentrations of doping may be provided. A donor carrier with areas containing different types and/or concentrations of doping may be provided. A donor carrier assembly may be provided that contains one or more donor carriers with different areas or a plurality of donor carriers with different types and/or concentrations of doping may be provided. Such a donor carrier assembly may be mounted at once in a light induce forward transfer manufacturing device.

### Brief description of the drawing

These and other objects and advantageous aspects will become apparent from a description of exemplary embodiments, using the following figures.
Figure 1 shows a LIFT manufacturing system
Figure 2 shows a target substrate and a donor plate in LIFT manufacturing
Figure 3 shows process flow for manufacturing a semi-conductor device
Figure 4 shows the light absorption coefficient of Si as a function of wavelength

### Detailed description of exemplary embodiments

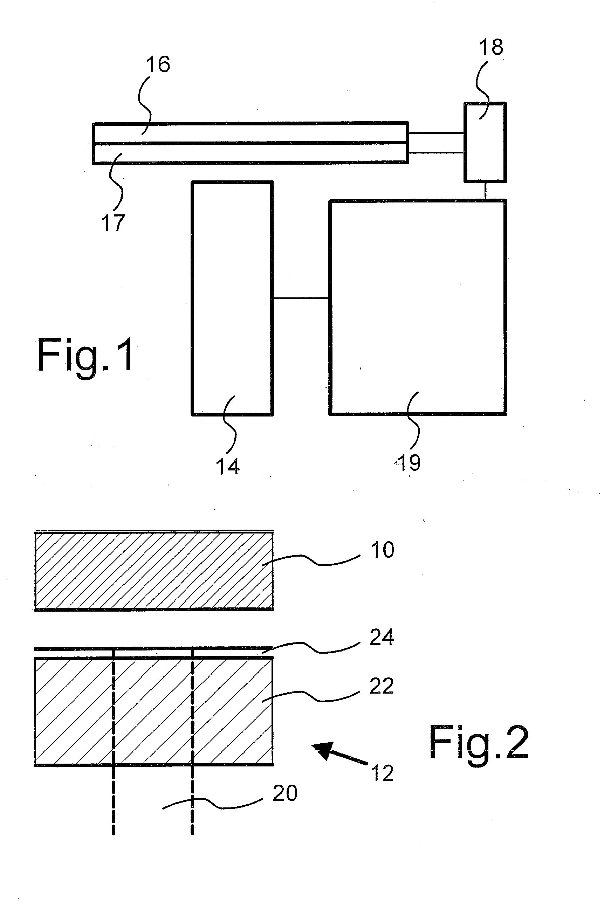

Figure 1 shows a laser induced transfer (LIFT) manufacturing system, for manufacturing a device on a target substrate, using material from one or more donor carriers. The system contains a laser system 14, a target mount 16 and donor mount 17, a positioning system 18, and a controller 19. Controller 19 is coupled to laser system 14 and positioning system 18. Laser system 14 is configured to generate laser pulses in a beam that defines a spot on the donor carrier in donor mount 17. Laser system 14 may contain a pulsed laser and optics to form the beam. Although an embodiment with a single spot will be described, it should be noted that laser system 14 may be configured to generate beams at a plurality of spots in parallel. Positioning system 18 is configured to position the target substrate in target mount 16 and one or more donor carriers 12 in donor mount 17 relative to the beam from laser system 14. Positioning system 18 may comprise actuators to move the target substrate and the donor carriers relative to each other and to the beam and/or to shift the position of the beam.

The donor carrier may be a rigid plate, made of glass for example, or a flexible carrier, like a foil, made of optically transparent polymer for example. In the description of embodiments donor plates will be used by way of example.

Figure 2 schematically shows a partial cross-section of target substrate 10 and a donor plate 12 in the LIFT manufacturing system, as well as the position of the laser beam 20. Donor plate 12 comprises a transparent donor substrate 22 and at least one layer of donor material 24. The cross-section is not to scale. Substrate 22 may be 1 mm thick for example and layer of donor material 24 may be 200 nm thick. The spot size may have diameter of 10 um (micrometer). In other examples a spot diameter in a range from the diffraction limit of the laser up till 200um may be used. The laser beam path is directed at layer of donor material 24 through transparent donor substrate 22. Target substrate 10 faces layer of donor material 24 from the side opposite to that of donor substrate 22.

In operation controller 19 causes laser system 14 to fire a laser pulse at a spot on layer of donor material 24. The laser light is absorbed in layer of donor material 24, causing the intensity of the laser beam to decrease with depth in layer of donor material 24. The absorption leads to heat generation at the spot in layer of donor material 24 during the duration of the pulse, the rate of direct heat generation decreasing with depth in layer of donor material 24 from the spot. The generated heat is transported through layer of donor material 24 to greater depth in the vicinity of the spot, causing layer of donor material 24 to melt at the spot. In addition, pressure generated between layer of donor material 24 and donor substrate 22 by the heating forces the molten layer of donor material 24 at the spot from donor substrate 22, from where it lands on target substrate 10. The molten layer of donor material 24 crystallizes on target substrate 10. A polycrystalline spot may be formed for example, or a single crystalline spot.

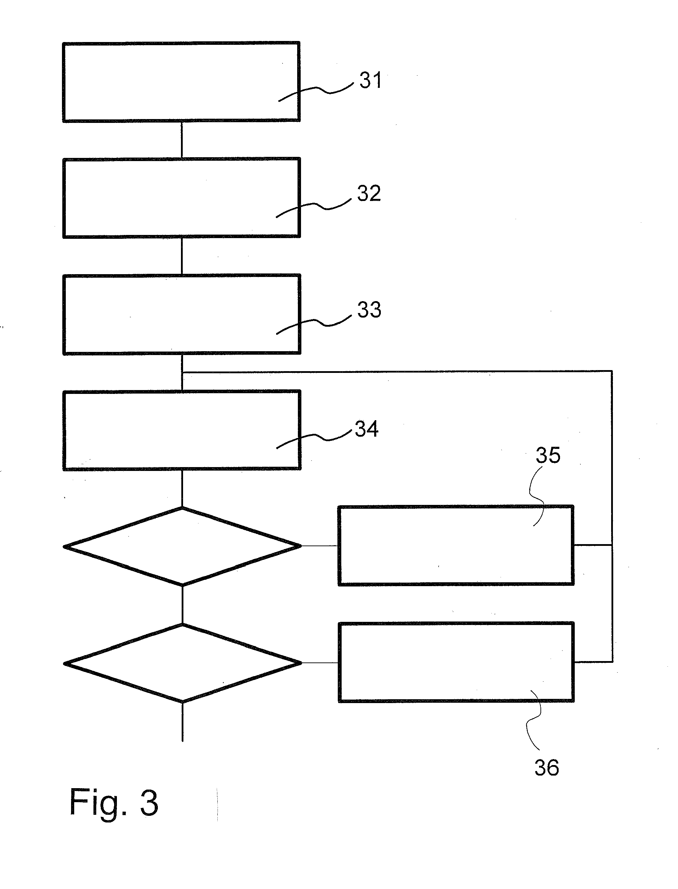

Figure 3 shows a process flow for manufacturing a semi-conductor device. In a first step 31 one or more donor plates are manufactured by providing one or more donor substrates, e.g. glass plates like quartz plates, or polymer plates, and depositing semi-conductor material (e.g. Si) on the donor substrates. Chemical vapor deposition may be used for example. The deposited semi-conductor material need not be crystalline: in an embodiment amorphous silicon is deposited. In an embodiment the thickness of the layer of semi-conductor material is 200 nanometer (nm), but a thickness in a range of 100-400 nm, or more generally 10-1000 nm may be used for example. The semi-conductor material may be provided directly on the donor substrate or, if there is a further material between the donor substrate and the deposited semi-conductor material, using only material or materials that transmit light to the semi-conductor material and do not melt or evaporate before the semi-conductor material during the process. Preferably, the semi-conductor material is provided directly on the donor substrate, which consists of a single layer of homogeneous material like glass or a polymer.

In a second step 32, doping material is added to the one or more donor plates. This may be done by implantation for example. In an embodiment, doping materials of different type (e.g. phosphorus and boron) are added on different donor plates, or different areas of a same donor plate. Thus a layer of donor material is formed that comprises semi-conductor material and doping material. Similarly, doping material of the same type may be added in different concentrations on different donor plates, or different areas of a same donor plate (as used herein the concentration is a ratio between doping material and semi-conductor material taken over the entire donor layer, e.g. an atomic ratio of doping atoms to silicon atoms, or a weight ratio). Concentrations in a range between 10¹³ to 10²¹ Atoms/cm³ may be used for example. In an embodiment, this may be combined with a further donor plate, or area of a donor plate with intrinsic (undoped) semi-conductor material. Thus layers of donor material with different doping materials and/or doping concentration may be formed.

In an alternative embodiment, first step 31 and second step 32 may be combined, semi-conductor material and doping material being deposited together, e.g. by CVD, using different types of doping material and/or different concentrations on different donor plates, or different areas of a same donor plate. Thus layers of donor material are formed. Use of CVD to deposit doping material is feasible if the required concentration is not too low. Otherwise, implantation is preferred.

In an alternative embodiment, part or all of the doping is deposited as a layer over the deposited semi-conductor material. In another or a further embodiment, semi-conductor material may be deposited over the doping material. Thus for example a sandwich with doping material between layers of semi-conductor material and/or a stack of alternate layers of doping material and semi-conductor material may be created. Thus composite layers of donor material may be formed that are each made up of a plurality of sub-layers. In an embodiment the thickness of the composite layer of semi-conductor material is 200 nanometer (nm), but a thickness in a range of 100-400 nm, or more generally 10-1000 nm may be used for example.

First and second step 31, 32 may be prefabrication steps, performed independent of manufacture involving the target substrate and independent of the semi-conductor device to be manufactured. As no device manufacture is directly involved, first and second step 31, 32 may be optimized separate from device manufacture to minimize costs and/or material parameters such as purity. First and second step 31, 32 may be performed by a party other than the party that performs the subsequent steps.

In a third step 33, a target substrate is mounted in laser induced transfer (LIFT) manufacturing system and one or more donor plates are mounted with the layer or layers containing semi-conductor material and doping material facing the target substrate.

In a fourth step 34, a laser pulse is fired at a spot on the donor layer through the donor substrate. In an exemplary process, a donor plate with a layer of amorphous silicon with a thickness of 100 nm was irradiated with a delivered energy density (fluence) of 0.361 J/cm2. A wavelength of 532 nm, a laser spot diameter of 69 micrometer, substantially larger than the layer thickness, and a pulse length of 17 ns was used. Raman measurements indicated that this resulted in transferred silicon with activated doping on the target substrate. Preferably, an energy density sufficient to melt the entire layer thickness at a location in the irradiated spot is used, but less than needed for full evaporation. As may be noted, when normalized for layer thickness, the energy dose per unit volume in the layer of donor material in this example corresponds to 0.361 J/cm2 per 100 nm donor layer thickness, i.e. 0.361E11 J/m3, which is higher than the energy needed to melt amorphous silicon (about 0.26E11 J/m3), but less than the energy needed for vaporizing amorphous silicon (about 0.95E11 J/m3). The process may be scaled to different layer thickness, spot size and pulse duration using such values of the energy dose per unit volume, and to other semi-conductor material in proportion to the resulting change in the heat needed to melt the donor layer. However, when the process is scaled it should be kept in mind that the effect of lateral heat diffusion in the layer, or heat loss to the environment may raise the required energy dose per layer volume when the spot size is decreased or the layer thickness is increased so that they becomes of the same order of magnitude, or the pulse duration is increased.

A laser pulse with a laser wavelength of 532 nm, a fluence of 0.138J/cm2 or 0.65J/cm2 and a pulse duration of between 1 to 25 nanosecond may be used for example. More generally, a fluence in a range of 1microJ/cm2 to 5J/cm2 may be used. More generally, a duration in a range from 100 fs to 10µs may be used for example. For certain applications a CW laser can also be employed.

Laser irradiation is used that causes the donor layer to melt over its entire thickness at the location of the spot. This may be controlled by selection of the laser energy density per unit volume in the layer of donor material in the spot. This may be controlled using the pulse duration, laser power density and the thickness of the donor layer. Heating by the laser pulse forces the molten donor layer at the spot off the donor substrate, causing it to land on the facing part of the target substrate, where it crystallizes. It has been found that the crystallization results in semi-conductor material with activated doping. Instead of a single laser pulse a temporal series of pulses may be used, with a distance between the pulses that is smaller than the time needed for full re-solidification of the material molten by the previous pulse.

When parallel beams are used, fourth step 34 may be used to transfer material (e.g. material with doping of the same type in the same concentration) to a plurality of locations in parallel, e.g. to a corresponding plurality of devices.

In an optional fifth step 35, the spot location is moved relative to the target substrate and the donor substrate, after which fourth step 34 is repeated for a different location on the target substrate and the donor substrate.

If the process has not yet been completed, a sixth step 36 is executed after fourth step 34, or after repetitions of fourth step 34. In sixth step 36 a different donor plate, or an area on the same donor plate, with a different doping material and/or concentration is moved to face the target substrate at or adjacent to the location or locations where donor material has been transferred to the target substrate. Subsequently, the process is repeated from fourth step 34.

In an embodiment wherein a lateral field effect transistor is manufactured, repetitions of fourth step 34 may be used to transfer spatially successive parts of the channel of the field effect transistor with different doping concentrations by transferring spots from donor layers of semiconductor material with different doping concentrations. Similarly, a part of the channel with opposite doping type compared to a remainder of the channel may be made by transfer in this way, from a donor layer with the opposite doping type. Source and drain areas of the field effect transistor may similarly be created by transfer from one or more donor plates.

In an embodiment wherein a lateral diode is manufactured, repetitions of fourth step 34 may be used to transfer spatially adjacent cathode and anode parts of the diode doping of opposite type by transferring spots from donor layers of semiconductor material with different doping types. Similarly, parts of the diode with the same type of doping but different concentrations may be made by transfer in this way, from donor layer with different doping concentrations. In another embodiment repetitions of fourth step 34 may be used to make different parts of a bipolar transistor.

In an embodiment wherein a vertical diode or transistor is manufactured, repetitions of fourth step 34 may be used to transfer spots from donor layers of semiconductor material with different doping types and/or concentration successively to a same location on the target substrate.

In addition to semi-conductor material, other materials like conductor material and/or isolator material may be transferred in additional steps using laser pulses applied to corresponding donor material. Isolator material may be transferred on top of a field effect transistor channel for example, to form a gate isolation. Conductor material may be transferred to form contacts, electrodes, antennas and/or capacitor plates. In addition to the laser transfer steps, manufacture of the device may comprise other steps like coating steps, etching steps, cleaning steps etc not described here.

In an embodiment a CMOS circuit comprising NMOS and PMOS transistors may be manufactured by transferring spots from donor layers of semiconductor material with opposite doping types as channels of the NMOS and PMOS transistors, or parts of these channels, and transferring spots of metal to form connections.

In an embodiment a memory circuit may be manufactured. For example, an EPROM, an SRAM and/or a DRAM circuit may be manufactured by manufacturing transistors combined with conductor lines and optionally capacitors with metal plates.

To form a crystalline semiconductor with activated doping from a donor layer containing semi-conductor material and doping material, it is desirable that the donor layer at the laser spot is entirely melted by the laser pulse or series of laser pulses. Furthermore, it is desirable that no damage is done to material on the target substrate by laser intensity that penetrates through the donor layer.

These requirements can be satisfied by selection of the donor layer thickness in combination with the laser wavelength, pulse duration and spatial power density. The light penetration depth in silicon depends on laser wavelength and to a limited extent also on doping (the light power density decreases according to exp(-z/d), wherein z is the distance from the donor substrate and d is the penetration depth value).

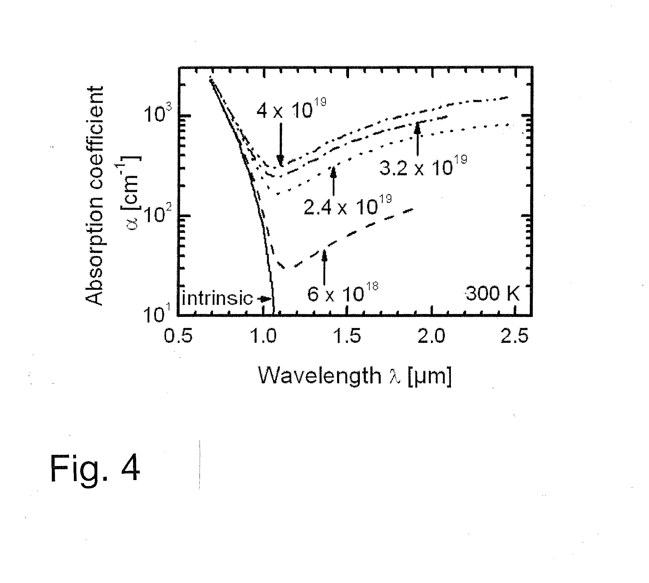

Figure 4 shows the light absorption coefficient of amorphous intrinsic Si expressed as alpha, the inverse of the penetration depth "d", as a function of wavelength as a solid line. Absorption coefficients at different n-type doping concentrations are shown by dashed lines. The absorption levels off below a wavelength of about 0.4 micrometer (not shown).

At some wavelengths in the red part of the spectrum silicon is highly transparent, which can have the effect that the laser intensity behind the donor layer can remain high, leading to damage to material on the target substrate and/or insufficient heat absorption to melt the donor layer. Preferably, the wavelength is selected to avoid this. For example, the absorption of light with a wavelength of 532 nm results in a penetration depth of substantially less than 100nm, so that this wavelength can be used for a layer of donor material with a layer thickness of 100 nm or more, and even smaller. On the other hand at some shorter wavelengths silicon highly absorbs light, leading to excessive local heating which may force the silicon off the donor substrate and onto the target substrate without substantial melting, which may lead to sub-optimal or even ineffective doped silicon on the target substrate. Preferably, a wavelength is used at which the penetration depth in the semi-donor layer is less than a fifth, and more preferably less than a tenth of the donor layer thickness, but more than 5nm and preferably more than 10nm. For silicon a laser wavelength in a range between 193nm to 1064nm may be used for example. In an embodiment 532 nm is used. For a relatively thicker donor layer preferably a wavelength with a proportionally larger penetration depth may be used.

At laser wavelengths below 400nm absorption to about 200nm amorphous silicon becomes substantially constant, whereas the absorption at 500nm and higher is less than half that below 400nm. It is advantageous to use laser wavelengths above 450nm and more preferably above 500nm to provide for more distributed heating.

In an embodiment, different laser wavelengths may be used for donor layers with different doping type and/or doping concentration. Doping type and/or doping concentration may affect penetration depth at a given wavelength, and the laser wavelength may be adapted to maintain substantially the same penetration depth when fourth step 34 is executed with donor layers of different doping type and/or doping concentration.

When a wavelength is used that corresponds to a penetration depth that is substantially smaller than the donor layer thickness, energy absorbed from the laser pulse must be passed through the full layer thickness in order to melt the donor layer before it has been transferred to the target substrate. A melting front may be formed that advances through the donor layer from the side of the donor substrate to the opposite side in time. The speed of such a melting front depends on heat diffusion and specific heat capacity of the material. Also, the more homogeneous the temperature becomes as a function of depth during melting, the better the electronic properties of the resulting material on the target substrate.

The duration of the laser pulse may be used to ensure full melting and/or to reduce temperature differences in the donor layer as a function of depth. The pulse may be temporally continuous or a sequence of sub-pulses, which functions as a continuous pulse with an effective power equal to the power of the sub-pulses times the duty cycle. The amount of energy needed to melt the donor layer is roughly proportional to donor layer thickness and spot area. The delivered amount of energy is determined by the spatial power density of the laser beam and laser pulse duration. When substantially the same amount of energy is delivered with a pulse of a first duration and first spatial power density or a pulse of a second, longer duration and second, lower spatial power density, the later may result in more complete melting before the donor layer has been transferred to the target substrate and/or a reduced temperature differences in the donor layer as a function of depth. Preferably, a pulse duration in a range between 1ns and 100ns is used for silicon, and a total energy per pulse of between O.lmJ and 10mJ.

Although embodiments using a circular laser spot have been described, it should be appreciated that alternatively different shape may be used. An oval spot may be used for example, to transfer elongated areas of semi-conductor material. Laser system 14 may be adjustable and controller 19 may be configured to cause laser system 14 to change the spot size or shape for different executions of fourth step 34. In another example, laser system 14 may comprise a mask in the beam path to define a shape of the beam on the donor material. For example, a substantially rectangular beam shape may be realized (e.g. rectangular but for deviations as a result of the finite wavelength). In a further example, a more complex shape with a network of lines may be realized. The shape and size of the transferred areas of semi-conductor material may also be controlled by means of a pattern of the donor material on the donor plate. In one embodiment, substantially rectangular pits with donor material may be provided on a donor plate, the laser spot having a size and shape that allows a pit to be illuminated as a whole. In this case the pit size and shape may be used to control the shape and size of the transferred area of semi-conductor material. Alternatively, a groove with donor material may be provided in a groove on the donor plate, the laser spot having a size that allows a section of the groove to be illuminated over the whole width of the groove. In this case the groove width may be used to determine the width of the transferred area. The groove may have a width of 100 nanometer for example, or a width in a range from 50 nm to 500 nm or 20 nm to 2000 nm, and the groove may have a length of at least one millimeter, for example up to a length of the donor plate. The groove may run along a straight line or a curved line such as a circle.

Although embodiments using a laser have been described, it should be appreciated that other types of narrow band light source may be used, such as a Xe or Na lamp.

Although embodiments with a transparent target substrate have been described, it should be realized that the target substrate need not be transparent. A transparent target substrate has the advantage that no or little light will be absorbed by the target substrate during LIFT transfer. But use of the donor layer to block light may already prevent excessive absorption. Moreover, light blocking by the donor layer also prevents damage to previously deposited material on the target substrate.

As described, a plurality of donor plates with donor layers comprising doping material of mutually different type and/or concentration in combination with the semiconductor material may be used to manufacture a device on a target substrate. In an embodiment, such a plurality of donor plates may be provided in an assembly wherein the donor plates are located parallel to each other so that the laser beam can be made to light each in turn by moving the assembly relative to the beam. Alternatively, such an assembly may be realized by means of a single donor plate on which doping material of mutually different type and/or concentration has been deposited at different areas on the donor plate. The assembly makes it possible to provide differently doped semi-conductor regions on the target substrate using a single donor plate assembly. The plurality of donor plates may also comprise donor plates, or plate areas, with a metal donor layer or a dielectric donor layer instead of semi-conductor material. This makes it possible to provide conductor regions and/or isolator regions in addition to the differently doped semi-conductor regions on the target substrate using a single donor plate assembly.

## Claims

1. A method of manufacturing a semi-conductor device, the method comprising
- providing an at least partly transparent donor substrate with a donor layer on a surface of the donor substrate, the donor layer comprising semi-conductor material and doping material;
- placing the donor substrate and a target substrate facing each other, with said surface of the donor substrate facing a surface of the target substrate;
- irradiating said donor layer with light through the donor substrate at a selected position or positions on the surface of the donor substrate, whereby the donor layer at said position or positions is melted and transferred to the target substrate.

2. A method according to claim 1, wherein said step of irradiating the donor layer is performed by means of a laser pulse.

3. A method according to any one of the preceding claims, wherein the semi-conductor material is silicon and the donor layer is irradiated with a pulse that a fluence between 0.1 J/cm2 and 1 J/cm2 per 100 nanometer of donor layer thickness.

4. A method according to any one of the preceding claims, wherein the donor layer comprises amorphous semi-conductor material.

5. A method according to any one of the preceding claims, wherein a doping in the donor layer is implanted doping.

6. A method according to any one of the preceding claims, wherein the doping layer comprises a layer of semiconductor material and a layer of doping material.

7. A method according to any one of the preceding claims, wherein a doping concentration in the donor layer lies in a range between 10¹³ to 10²¹ doping atoms/cm³

8. A method according to claim 1, wherein the donor layer has a thickness in a range between 50 nanometer and 1000 nanometer.

9. A method according to claim 1, wherein said step of irradiating the donor layer is performed by means of a laser pulse, at a wavelength at which the donor layer has a light penetration depth less than the thickness of the donor layer.

10. A method according to claim 1, the method comprising depositing a plurality of successively adjacent regions of semi-conductor material with mutually different doping type and/or doping concentration on the target substrate by successively irradiating respective different donor layers or different areas of a donor layer, where the donor layers or the donor layer comprise the semi-conductor material in combination with doping material of different type and/or concentration, whereby irradiated parts of the donor layers or layer are melted and transferred to the target substrate.

11. A method according to claim 10, wherein the plurality of successively adjacent regions are transferred to the target substrate at laterally successive adjacent locations on the target substrate.

12. A method according to claim 10, wherein the plurality of successively adjacent regions are transferred to the target substrate at successively on top of each other on the target substrate.

13. A method according to claim 10, wherein light of first and second, mutually different wavelength composition is used to transfer a first and second of plurality of successively adjacent regions.

14. A donor carrier for use in light assisted forward transfer with a method as claimed in claim 1, wherein the donor carrier comprises
- an at least partly transparent donor substrate
- a donor layer on a surface of the donor substrate, the donor layer comprising semi-conductor material and doping material.

15. A donor carrier as claimed in claim 14, wherein the doping material is implanted donor material in the semi-conductor material.

16. A donor carrier as claimed in claim 14, wherein the semi-conductor material is provided on the donor substrate without material between the semi-conductor material and the donor substrate that will melt or evaporate before the semi-conductor material during heating of the semi-conductor material by irradiation of the semi-conductor material through the donor substrate.

17. A donor carrier assembly comprising a donor carrier according to claim 14, the donor layer on said donor carrier or on said donor carrier and a further donor carrier in the donor carrier assembly comprising doping material of different type and/or concentration in different areas on said donor carrier or on said donor carrier and the further donor carrier.
